# EUROPEAN PATENT APPLICATION

(11) **EP 3 608 848 A1**
(43) Date of publication of application: **12.02.2020**
(21) Application number: 17903748.6
(22) Date of filing: 28.03.2017
(51) Int. Cl.: G06Q 10/04

(54) **METHOD AND DEVICE FOR USE IN ESTIMATING LIFECYCLE OF COMPONENT**

(71) Applicant: Siemens Aktiengesellschaft, 80333 München (DE)
(72) Inventor: YUAN, Yong, Beijing 102208 (CN); WANG, Xiaofeng, Beijing 100107 (CN); ZHOU, Wenjing, Wuxi Jiangsu 214122 (CN)
(74) Representative: Isarpatent
(86) International application number: PCT/CN2017/078357
(87) International publication number: WO 2018/176203

(57) **Abstract**

Provided in the present invention are a method for estimating the lifecycle of a component. The method comprises: acquiring model description information corresponding to component models for some or all components in the production line by utilizing a simulation device; acquiring at least one piece of data information required by at least one component model corresponding to the model description information; event tagging the acquired data information on the basis of the event information; acquiring, on the basis of the data information tagged, component state information corresponding to the components corresponding to the models; and generating a corresponding analysis report on the basis of the state information from the components. The advantage of the present invention is such that: manual operation by and experience of an expert is no longer relied on to determine a failure mode, a key component, and a measurement rule, corresponding information can rather be provided with precision via a PLM system. Moreover, by means of semantic processing of the models, support is provided for user remote operation. Improved adaptation to diverse office scenarios is allowed.

## Description

### Technical Field

The present invention relates to the field of industrial Internet, and in particular relates to a method and device for estimating the lifecycle of a component.

### Background Art

To save the maintenance cost and provide reliable product and operation models, small and medium enterprises (SMEs) have a strong demand for the product data service. For example, an SME which has established assembly lines adopts the preventive maintenance service so as to acquire data from key components in the production lines, transmit data to a cloud, and use an analytical algorithm to analyze the key components to predict possible failure cases of the key components. Thus, the maintenance cost is lowered, the inventory of redundant components is reduced, and components can be replaced in time so as to reduce the system risk of the production lines.

The industrial Internet makes the product data service more convenient. In order to carry out the product data service in a specific production field, it is necessary to perform the following steps: 1) start the failure mode and effects analysis for a client factory to determine the key products in the production lines and their failure mode; 2) determine the measurement rules, including the installation of sensors and preprocessing of sensor data; 3) install sensors and data acquiring software/hardware on site; 4) configure the parameters of the cloud connector and describe the correlation between the components in the factory on the cloud; 5) configure the report template and the visual interface; 6) provide a report and a visual interface according to the analysis result.

However, it is not easy to execute the method in practice for the following reasons:
1) the determination of key modules and their failure mode heavily depends on the experience of experts;
2) the measurement rules highly depends on the experience of experts;
3) the quality of an analysis report and a visual interface highly depends on the experience of experts.

In addition, the current analysis mode is mainly the black box mode. However, since key components need to depend on data sampling in normal mode and failure mode, it is not easy to obtain the black box of each different component.

### Summary of the Invention

In view of this, one problem solved by one embodiment of the present invention is to automatically realize the estimation of the lifecycle of a component and thus avoid the overdependence on the experience of experts.

According to one embodiment of the present invention, a method for estimating the lifecycle of a component is provided, wherein said estimation device includes a simulation device used to model and simulate each component in a production line, wherein said method comprises the following steps:
- use said simulation device to acquire the corresponding model description information of some or all components in said production line, wherein said model description information includes at least a piece of data information which corresponds to at least a component model and is required to be collected, and event information respectively corresponding to each piece of data information;
- acquire at least a piece of data information required by at least a component model corresponding to said model description information;
- add event tags to the acquired data information based on said event information;
- acquire the component status information of the corresponding component of each model based on the tagged data information; and
- generate a corresponding analysis report based on said component status information.

According to one embodiment of the present invention, an estimation device for estimating the lifecycle of a component is provided, wherein said estimation device includes a simulation device used to model and simulate each component in a production line, wherein said estimation device comprises:
said simulation device, used to acquire the corresponding model description information of some or all components in said production line, wherein said model description information includes at least a piece of data information which corresponds to at least a component model and is required to be collected, and event information respectively corresponding to each piece of data information;
a data acquisition device, used to acquire at least a piece of real data information required by at least a component model corresponding to said model description information, and add event tags to the acquired real data information based on said event information;
a status monitoring device, used to acquire the component status information of the corresponding component of each model based on the tagged data information; and
an analysis device, used to generate a corresponding analysis report based on said component status information.

Compared with the prior art, the present invention has the following advantage: By simulating a production line and outputting data information and event rules required for key components, the system can automatically be directed to acquire corresponding real data, automatically collect and preprocess proper data, and collect real data for the product lifecycle management (PLM) system to perform calibrations, and thus a closed loop is formed. Then, the simulation model of the whole production line more fits the actual situation. In addition, the determination of the failure mode, key components and measurement rules no longer depends on manual operations and experience of experts, and the corresponding information can precisely be provided through the PLM system. In addition, support for remote operations can be provided for the user through semantic processing of the models. Diversified office scenarios can be fitted better.

### Brief Description of the Drawings

The following detailed description in combination with the drawing will make more obvious other features, characteristics, advantages and benefits of the present invention.
Fig. 1 is a flowchart of the method for estimating the lifecycle of a component according to one embodiment of the present invention.
Fig. 2 is a block diagram of the estimation device for estimating the lifecycle of a component according to one embodiment of the present invention.
Fig. 3 is a general block diagram of the estimation device according to one embodiment of the present invention.

### Detailed Description of the Invention

The preferred embodiments of the present disclosure will be described in detail by reference to the drawings. Although the preferred embodiments of the present disclosure are shown in the drawings, it should be understood that the present disclosure can be realized in various forms and should not be restricted by the embodiments described here. On the contrary, these embodiments are provided to make the present disclosure more thoroughly and completely understood and completely deliver the scope of the present disclosure to those skilled in the art.

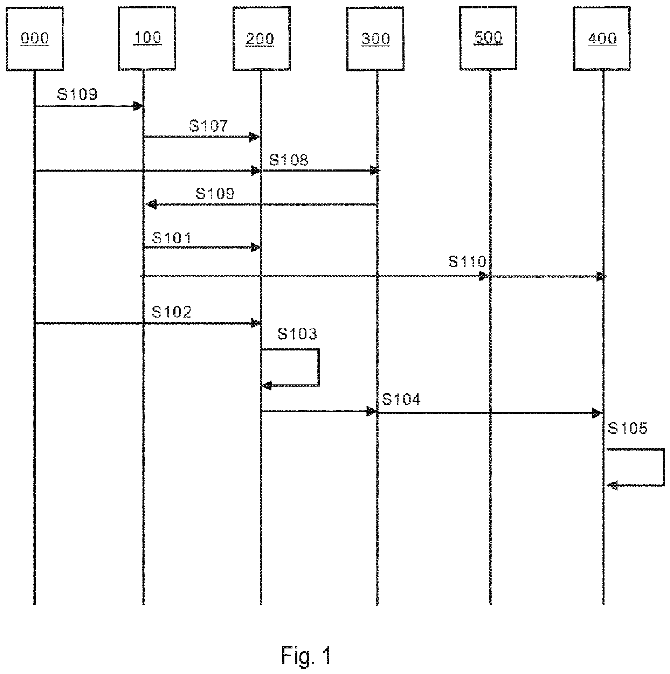

See Fig. 1. Fig. 1 shows the estimation device for estimating the lifecycle of a component according to one embodiment of the present invention. The estimation device according to the present invention comprises a simulation device 100, a data acquisition device 200, a status monitoring device 300, and an analysis device 400, and preferably, the estimation device according to the present invention further comprises a semantic device 500.

The following gives some embodiments to describe the present invention.

One embodiment according to the present invention comprises step S101 performed by the simulation device 100, steps S102 and S103 performed by the data acquisition device 200, step S104 performed by the status monitoring device 300 and step S105 performed by the analysis device 400.

Wherein the simulation device is used to model and simulate each component in a production line. Preferably, a PLM software is used for said simulation device to model each component in a production line of a factory and generate the corresponding simulation data for the corresponding model of each component to run.

Specifically, in step S101, the estimation device utilizes the simulation device to acquire the model description information corresponding to the component model of at least a component in said production line.

Wherein said model description information includes at least a piece of data information required to be collected for the component model, and event information corresponding to part or all of data information.

Wherein the corresponding event in said event information is used to distinguish between the normal mode and the failure mode of a component model at the time of running.

Preferably, for any component model, the estimation device extracts the corresponding rules information of the component model according to the simulation running of the component model in normal mode and failure mode, and said rules information includes event information and data information corresponding to said event information.

Wherein said event information is used to distinguish between normal mode and failure mode.

Specifically, simulation running is performed for a component model in the simulation device of the estimation device based on a plurality of groups of simulation data, including simulation data in normal mode and simulation data in failure mode, and a plurality of running results are obtained. In addition, event information used to distinguish between normal mode and failure mode, and the corresponding data information of the event are extracted as rules information through data mining and other data processing modes.

For example, at the simulation running of the motor model, the corresponding vibration amplitude of the motor is obtained based on the simulation data such as temperature, speed and load or no load. The simulation device determines the vibration amplitude in failure mode according to the normal range of the vibration amplitude, determines that the event formation used to distinguish between normal mode and failure mode is load, and then determines the rules include on-load vibration data. According to the corresponding data information, the simulation device determines that the rules include the on-load vibration amplitude, then determines that the event information is load, and determines that the data information required to be acquired includes temperature, speed, load or no load, and vibration.

Preferably, the estimation device utilizes said simulation device to perform simulation running so as to determine at least a key component in said production line based on the association relationship and/or corresponding failure mode of each component in said production line during the simulation running and acquire the model description information of said at least a key component.

For example, the simulation device can determine a component located on a key node to be a key component based on the association relationship between a component and other components. Again for example, the simulation device can determine a component with a plurality of failure modes and a high failure rate to be a key component.

Then, the estimation device acquires the model description information of at least a model from the simulation device, and in step S102, the estimation device acquires at least a piece of real data information corresponding to said model description information of each model.

Wherein the estimation device has interfaces connecting each component in the real production line to acquire data information related to each component.

Preferably, the estimation device is connected with the devices for collecting data, such as the sensor on each real component, through the interfaces to acquire the components' real data collected by these devices.

Then, in step S103, the estimation device adds event tags to the acquired data information based on said event information.

Preferably, the estimation device preprocesses the acquired data information so as to add event tags to the preprocessed data information.

Wherein said preprocessing includes but is not limited to a plurality of possible data processing modes, for example, filtering data and finding root mean square of data.

Wherein the estimation device can determine the preprocessing operations on data according to the data type and the data source.More preferably, data can be preprocessed based on the preprocessing rules preset at the time of component modeling.

Then, in step S104, the estimation device acquires the component status information of the corresponding component of each model based on the tagged data information.

Wherein said running status information is used to indicate whether a component model is in normal mode or failure mode. Preferably, said running status information includes the probability of the component model being in normal mode/failure mode. More preferably, said running status information further includes other related information indicating that the component model is in normal/failure mode. Specifically, the estimation device determines the component status information of the corresponding component of data information based on the event tags contained in the data information.

Then, in step S105, the estimation device generates a corresponding analysis report based on the component status information coming from said status monitoring device.

Specifically, the estimation device predicts the lifecycle of the component based on the acquired component status information of each component model and historically acquired component status information, and generates a corresponding analysis report based on the predicted lifecycle.

Preferably, the estimation device further acquires other component-related information of the component, combines it with the component status information of the component model and the running status information of the component to predict the lifecycle of the component, and generates a corresponding analysis report based on the predicted lifecycle.

Wherein said component-related information includes various information provided for the estimation device to predict the lifecycle of the component.

Preferably, said component-related information includes but is not limited to at least one item of the following:
1) health index information of the component, for example, degree of aging, degree of wear and deformation of the component
2) running time of the component
3) information about the position of the component in the production line

According to a first embodiment of the present invention, a component model is a motor model and it is known that the model is in failure mode when the speed of revolution is greater than 100 rpm and vibrations are sensitive to the speed of revolution.

Two failure modes determined through simulation running of the model:
1) bearing failure: Vib=f1(Speed, Torque, Temperature);
2) transmission shaft failure: Vib=f2(Speed, Torque, Temperature) .
Wherein Vib represents the vibration data, Speed represents the speed, Torque represents the torque, Temperature represent the temperature, f1 represents the corresponding function of the bearing failure mode, and f2 represents the corresponding function of the transmission shaft failure mode.

Then the corresponding model description information which the estimation device abstractly determines to acquire in step S102 includes data items such as speed, torque, temperature and vibration and rules information such as vibration data when the speed is greater than 100 rpm.

In step S103, the estimation device acquires the corresponding real data values of the four data items from the sensors of the actual motor and tags the vibration data satisfying the event information with the symbol event_1, and the corresponding event content of the symbol is "speed is greater than 100 rpm."

Then, the estimation device acquires the corresponding data information of the motor model and determines the component status information of the motor based on the acquired information in step S104, and predicts the lifecycle of the motor based on the determined component status information in step S105.

Further see Fig. 1. In a preferred embodiment, the method further comprises steps S110 and S105'.

In step S110, said estimation device sends the position semantic information of the corresponding component to the analysis device.

Wherein in said position semantic information represents the information after semantic processing of the position association relationships between components. Preferably, said position association relationships include the relative position relationships between components, such as up-and-down relationship, left-and-right relationship and front-and-back relationship.

Preferably, after said estimation device establishes/updates the simulation model of the production line, the semantic device reads the position association relationships between different component models in the simulation device and performs semantic processing to obtain the position semantic information of the position association relationships between different components.

Specifically, the estimation device determines the information about position associations between different component models by reading related documents of different component models in the simulation modeling of the production line.

When the models are changed, the estimation device updates the corresponding information about position associations by reading the documents of changed component models.

Then, in step S105', the estimation device generates a corresponding analysis report based on the component status information coming from said status monitoring device and the association semantic information corresponding to a corresponding component.

Wherein said analysis report can contain at least any piece of the following information:
1) lifecycle of a component
2) data information of a component
3) lifecycle of a production line

According to a preferred solution of the embodiment, said estimation device has a remote client and said estimation device provides the remote client with the association semantic information corresponding to each component.

Specifically, when the user views the running status and the analysis report of the estimation device through the remote client, the estimation device sends the required analysis data and position semantic information to the remote client for the user to view.

For example, the estimation device can send the required analysis data and position semantic information to a cloud respectively so that the remote client can acquire the corresponding data.

According to the solution of the present embodiment, full-automatic estimation can be realized, without any dependence on the experience of experts. In addition, support for remote operations can be provided for the user through semantic processing of the models. Diversified office scenarios can be fitted better.

Continue to see Fig. 1. According to a preferred solution of the present invention, before step S101, the method further comprises steps S106, S107, S108 and S109.

In step S106, the estimation device sets up the corresponding component model of each component in the production line based on the simulation device.

In step S107, the estimation device acquires the corresponding real data information of each component model in said simulation device.

In step S108, the estimation device generates the corresponding model data of each component model based on each component model in said simulation device and the corresponding real data information of each component model.

Wherein model data includes data information containing model information. Model data is acquired by encapsulating model information and real data information.

For example, model information can contain the device name corresponding to the real data information, device sensor information and attributes of data acquired by sensors. Those skilled in the art can determine the model information to be adopted in model data according to the practical conditions and requirements. Specifically, the estimation device consolidates the corresponding real data information based on the data formats required for each component model to acquire the corresponding model data.

Then, in step S109, the estimation device calibrates the corresponding component model of said each component based on said model data.

Wherein those skilled in the art should know the way of calibrating a model based on model data, and it is not described again here.

According to the solution of the present embodiment, by simulating a production line and outputting data information and event rules required for key components, the system can automatically be directed to acquire corresponding real data, automatically collect and preprocess proper data, and collect real data for the PLM system to perform calibrations, and thus a closed loop is formed. Then, the simulation model of the whole production line more fits the actual situation. In addition, the determination of the failure mode, key components and measurement rules no longer depends on manual operations and experience of experts, and the corresponding information can precisely be provided through the PLM system.

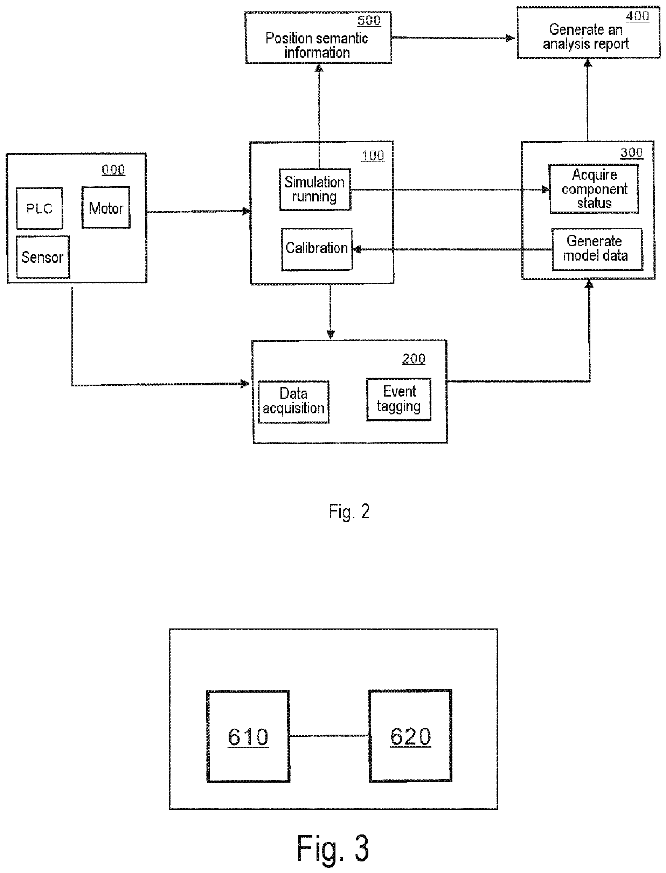

Fig. 2 is a block diagram of the estimation device for estimating the lifecycle of a component according to one embodiment of the present invention. The estimation device according to the present invention comprises a simulation device 100, a data acquisition device 200, a status monitoring device 300, and an analysis device 400, and preferably, the estimation device according to the present invention further comprises a semantic device 500.

Wherein the simulation device 100 is used to model and simulate each component in a production line. Preferably, a PLM software is used for said simulation device 100 to model each component in a production line of a factory and generate the corresponding simulation data for the corresponding model of each component to run.

Specifically, the simulation device 100 acquires the model description information corresponding to the component model of at least a component in said production line.

Wherein said model description information includes at least a piece of data information required to be collected for the component model, and event information corresponding to part or all of data information.

Wherein the corresponding event in said event information is used to distinguish between the normal mode and the failure mode of a component model at the time of running.

Preferably, for any component model, the simulation device 100 extracts the corresponding rules information of the component model according to the simulation running of the component model in normal mode and failure mode, and said rules information includes event information and data information corresponding to said event information.

Wherein said event information is used to distinguish between normal mode and failure mode.

Specifically, simulation running is performed for a component model in the simulation device 100 based on a plurality of groups of simulation data, including simulation data in normal mode and simulation data in failure mode, and a plurality of running results are obtained. In addition, event information used to distinguish between normal mode and failure mode, and the corresponding data information of the event are extracted as rules information through data mining and other data processing modes.

For example, at the simulation running of the motor model, the corresponding vibration amplitude of the motor is obtained based on the simulation data such as temperature, speed and load or no load. The simulation device 100 determines the vibration amplitude in failure mode according to the normal range of the vibration amplitude, determines that the event formation used to distinguish between normal mode and failure mode is load, and then determines the rules include on-load vibration data. According to the corresponding data information, the simulation device determines the rules include the on-load vibration amplitude, then determines that the event information is load, and determines that the data information required to be acquired includes temperature, speed, load or no load, and vibration.

Preferably, the estimation device 100 utilizes said simulation device to perform simulation running so as to determine at least a key component in said production line based on the association relationship and/or corresponding failure mode of each component in said production line during the simulation running and acquire the model description information of said at least a key component.

For example, the simulation device 100 can determine a component located on a key node to be a key component based on the association relationship between a component and other components. Again for example, the simulation device can determine a component with a plurality of failure modes and a high failure rate to be a key component.

Then, the data acquisition device 200 receives the model description information of at least a model from the simulation device 100, and acquires at least a piece of real data information corresponding to said model description information of each model.

Wherein the data acquisition device 200 has interfaces connecting each component in the real production line to acquire data information related to each component.

Preferably, the data acquisition device 200 is connected with the devices for collecting data, such as the sensor on each real component, through the interfaces to acquire the components' real data collected by these devices.

Then, the data acquisition device 200 adds event tags to the acquired data information based on said event information.

Preferably, the data acquisition device 200 preprocesses the acquired data information so as to add event tags to the preprocessed data information.

Wherein said preprocessing includes but is not limited to a plurality of possible data processing modes, for example, filtering data and finding root mean square of data.

Wherein the data acquisition device 200 can determine the preprocessing operations on data according to the data type and the data source. More preferably, data can be preprocessed based on the preprocessing rules preset at the time of component modeling.

Then, the status monitoring device 300 acquires the component status information of the corresponding component of each model based on the tagged data information.

Wherein said running status information is used to indicate whether a component model is in normal mode or failure mode. Preferably, said running status information includes the probability of the component model being in normal mode/failure mode. More preferably, said running status information further includes other related information indicating that the component model is in normal/failure mode.

Specifically, the estimation device determines the component status information of the corresponding component of data information based on the event tags contained in the data information.

Specifically, the status monitoring device 300 detects the running status of the corresponding component according to the data information corresponding to the failure mode and normal mode of a component model in the simulation device so that the analysis device 400 can predict the lifecycle of the component based on the running status.

Then, the analysis device 400 generates a corresponding analysis report based on the component status information coming from said status monitoring device.

Specifically, the analysis device 400 predicts the lifecycle of the component based on the acquired component status information of each component model and historically acquired component status information, and generates a corresponding analysis report based on the predicted lifecycle.

Preferably, the analysis device 400 further acquires other component-related information of the component, combines it with the component status information of the component model and the running status information of the component to predict the lifecycle of the component, and generates a corresponding analysis report based on the predicted lifecycle.

Wherein said component-related information includes various information provided for the estimation device to predict the lifecycle of the component.

Preferably, said component-related information includes but is not limited to at least one item of the following:
1) health index information of a component, for example, degree of aging, degree of wear and deformation of the component
2) running time of the component
3) information about the position of the component in the production line

According to a first embodiment of the present invention, a component model is a motor model and it is known that in the PLM system the model is in failure mode when the speed of revolution is greater than 100 rpm and vibrations are sensitive to the speed of revolution.

Two failure modes determined through simulation running of the model:
1) bearing failure: Vib=f1(Speed, Torque, Temperature);
2) transmission shaft failure: Vib=f2(Speed, Torque, Temperature) .

Wherein Vib represents the vibration data, Speed represents the speed, Torque represents the torque, Temperature represents the temperature, f1 represents the corresponding function of the bearing failure mode, and f2 represents the corresponding function of the transmission shaft failure mode.

Then the corresponding model description information which the data acquisition device 200 abstractly determines to acquire includes data items such as speed, torque, temperature and vibration and rules information such as vibration data when the speed is greater than 100 rpm.

The data acquisition device 200 acquires the corresponding real data values of the four data items from the sensors of the actual motor and tags the vibration data satisfying the event information with the symbol event_1, and the corresponding event content of the symbol is "speed is greater than 100 rpm."

Then, the status monitoring device 300 acquires the corresponding data information of the motor model and determines the component status information of the motor based on the acquired information, and the analysis device 400 predicts the lifecycle of the motor based on the determined component status information.

Further see Fig. 2. In a preferred embodiment, the estimation device further comprises a semantic device 500.

The semantic device 500 sends the position semantic information of a corresponding component to the analysis device 400.

Wherein said position semantic information represents the information after semantic processing of the position association relationships between components. Preferably, said position association relationships include the relative position relationships between components, such as up-and-down relationship, left-and-right relationship and front-and-back relationship.

Preferably, after said simulation device establishes/updates the simulation model of the production line, the semantic device 500 reads the position association relationships between different component models in the simulation device and performs semantic processing to obtain the position semantic information of the position association relationships between different components.

Specifically, the semantic device 500 determines the information about position associations between different component models by reading related documents of different component models in the simulation modeling of the production line. When the models are changed, the semantic device updates the corresponding information about position associations by reading the documents of changed component models.

Then, the analysis device 400 generates a corresponding analysis report based on the component status information coming from said status monitoring device and the position semantic information corresponding to a corresponding component.

Wherein said analysis report can contain at least any piece of the following information:
1) lifecycle of a component
2) data information of a component
3) lifecycle of a production line

According to a preferred solution of the embodiment, said estimation device has a remote client and said semantic device 500 provides the remote client with the association semantic information corresponding to each component.

Specifically, when the user views the running status and the analysis report of the estimation device through the remote client, the semantic device 500 and the analysis device 400 send the required analysis data and position semantic information to the remote client for the user to view.

For example, the semantic device 500 and the analysis device 400 can send the required analysis data and position semantic information to a cloud respectively so that the remote client can acquire the corresponding data.

According to the solution of the present embodiment, full-automatic estimation can be realized, without any dependence on the experience of experts. In addition, support for remote operations can be provided for the user through semantic processing of the models. Diversified office scenarios can be fitted better.

Continue to see Fig. 2. According to a preferred solution of the present invention, the simulation device 100 sets up the corresponding component models of different components in the production line, then the data acquisition device 200 acquires the corresponding data information of different component models in said simulation device, then the status monitoring device 300 generates model data corresponding to different component models based on different component models in said simulation device and the data information coming from the data acquisition device 200 and corresponding to different component models. Then, the simulation device 100 calibrates the corresponding component models of said different components based on the model data of the status monitoring device 300.

Wherein model data includes data information containing model information. Model data is acquired by encapsulating model information and real data information.

For example, model information can contain the device name corresponding to the real data information, device sensor information and attributes of data acquired by sensors. Those skilled in the art can determine the model information to be adopted in model data according to the practical conditions and requirements.

Wherein those skilled in the art should know the way of calibrating a model based on real model data, and it is not described again here.

According to the solution of the present embodiment, by simulating a production line and outputting data information and event rules required for key components, the system can automatically be directed to acquire corresponding real data, automatically collect and preprocess proper data, and collect real data for the PLM system to perform calibrations, and thus a closed loop is formed. Then, the simulation model of the whole production line more fits the actual situation. In addition, the determination of the failure mode, key components and measurement rules no longer depends on manual operations and experience of experts, and the corresponding information can precisely be provided through the PLM system.

The devices in Fig. 2 can be realized by software, hardware (for example, integrated circuits and field programmable gate array (FPGA)), or the combination of software and hardware.

Now see Fig. 3, which is a general block diagram of the estimation device according to one embodiment of the present invention. The estimation device can comprise a storage 610 and a processor 620. The storage 610 can store executable instructions. The processor 620 can realize the operations performed by different devices in Figs. 4-6 according the executable instructions stored in the storage 610.

In addition, the embodiments of the present invention further provide a machine readable medium. The machine readable medium stores executable instructions, and when said executable instructions are executed, the machine executes the operations realized by the estimation device.

Those skilled in the art should understand that variations and changes can be made without departing from the essence of the present invention. Therefore, the scope of protection of the present invention should be defined by the attached claims.

## Claims

1. A method for estimating the lifecycle of a component, wherein said method comprises the following steps:
- use of a simulation device to acquire the corresponding model description information of the component models of some or all components in said production line, wherein said model description information includes at least a piece of data information which corresponds to at least a component model and is required to be collected, and event information respectively corresponding to each piece of data information;
- acquiring at least a piece of data information required by at least a component model corresponding to said model description information;
- adding event tags to the acquired data information based on said event information;
- acquiring the component status information of the corresponding component of each model based on the tagged data information; and
- generating a corresponding analysis report based on said component status information.

2. The method as claimed in claim 1, wherein said method further comprises the following step:
- acquiring the association semantic information of a corresponding component;
wherein said step of generating an analysis report further comprises:
- generating the corresponding analysis report based on the component status information coming from said status monitoring device and the association semantic information corresponding to a corresponding component.

3. The method as claimed in claim 1 or 2, wherein said method further comprises the following step:
- reading the position association relationships between different component models in the simulation device and performing semantic processing to obtain the position semantic information of the position association relationships between different components after said simulation device establishes/updates the simulation model of the production line.

4. The method as claimed in claim 1 or 2, wherein said method further comprises the following step:
- providing a remote client with the corresponding position semantic information of each component.

5. The method as claimed in claim 1 or 2, wherein said method further comprises:
- said simulation device performing simulation running so as to determine at least a key component in said production line based on the corresponding failure mode of each component in said production line during the simulation running and acquiring the model description information of said at least a key component.

6. The method as claimed in claim 1 or 2, wherein said step of acquiring the model description information of a component model further comprises:
- said simulation device extracting the corresponding rules information of the component model according to the simulation running of the component model in normal mode and failure mode, and determining the event information corresponding to said rules information, and at least a piece of data information corresponding to said event information.

7. The method as claimed in claim 1 or 2, wherein said method further comprises the following step:
- preprocessing the acquired data information so as to add event tags to the preprocessed data information.

8. The method as claimed in claim 1 or 2, wherein said method further comprises the following steps:
- setting up the corresponding component model information of each component in the production line based on the simulation device;
- acquiring the corresponding real data information of each component model in said simulation device;
- generating the corresponding model data of each component model based on each component model in said simulation device and the corresponding real data information of each component model; and
- calibrating the corresponding component model based on said model data.

9. An estimation device for estimating the lifecycle of a component, wherein said estimation device comprises:
a simulation device, used to acquire the corresponding model description information of some or all components in said production line, wherein said model description information includes at least a piece of data information which corresponds to at least a component model and is required to be collected, and event information corresponding to each piece of data information;
a data acquisition device, used to acquire at least a piece of real data information required by at least a component model corresponding to said model description information, and adding event tags to the acquired real data information based on said event information;
a status monitoring device, used to acquire the component status information of the corresponding component of each model based on the tagged data information; and
an analysis device, used to generate a corresponding analysis report based on said component status information.

10. The estimation device as claimed in claim 9, wherein said estimation device further comprises a semantic device which can acquire the association relationships between different components in the simulation device,
and said semantic device is used to send the association semantic information of a corresponding component to the analysis device;
wherein said analysis device generates a corresponding analysis report based on the component status information coming from said status monitoring device and the association semantic information coming from said semantic device and corresponding to a corresponding component.

11. The estimation device as claimed in claim 9 or 10, wherein said semantic device is further used to:
- read the position association relationships between different component models in the simulation device and perform semantic processing to obtain the position semantic information of the position association relationships between different components after said simulation device establishes/updates the simulation model of the production line.

12. The estimation device as claimed in claim 9 or 10, wherein said estimation device can correspond to a remote client and said semantic device provides said remote client with the corresponding association semantic information of each component.

13. The estimation device as claimed in claim 9 or 10, wherein said simulation device performs simulation running so as to determine at least a key component in said production line based on the corresponding failure mode of each component in said production line during the simulation running and acquire the model description information of said at least a key component.

14. The estimation device as claimed in any of claims 9 to 13, wherein said simulation device extracts the corresponding rules information of a component model according to the simulation running of the component model in normal mode and failure mode, and determines the event information corresponding to said rules information, and at least a piece of data information corresponding to said event information.

15. The estimation device as claimed in claim 9 or 10, wherein said data acquisition device preprocesses the acquired data information so as to add event tags to the preprocessed data information.

16. The estimation device as claimed in claim 9 or 10, wherein
said simulation device is further used to set the corresponding component model of each component in the production line;
said data acquisition device is further used to acquire said each component model and the real data information corresponding to said each component model;
said status monitoring device is further used to generate the corresponding model data of each component model based on each component model in said simulation device and the corresponding real data information of each component model; and
said simulation device is further used to calibrate the corresponding component model based on said model data.
